# EUROPÄISCHE PATENTANMELDUNG

(11) **EP 3 410 131 A1**
(43) Veröffentlichungstag der Anmeldung: **05.12.2018**
(21) Anmeldenummer: 18161346.4
(22) Anmeldetag: 13.03.2018
(51) Int. Cl.: G01R 31/12

(54) **VERFAHREN UND ANORDNUNG ZUM LOKALISIEREN EINER ELEKTRISCHEN ENTLADUNG IN EINER ELEKTRISCHEN ANLAGE**

(30) Priorität: 09.05.2017 DE 102017207818
(71) Anmelder: Siemens Aktiengesellschaft, 80333 München (DE)
(72) Erfinder: Hartmann, Dirk, 85617 Aßling (DE); Stelzig, Philipp Emanuel, 97616 Bad Neustadt a.d. Saale (DE); Wannerberg, Erik Olof Johannes, 80796 München (DE)

(57) **Zusammenfassung**

Erfindungsgemäß werden ein Entladungszeitpunkt (TE) einer elektrischen Entladung (EE) sowie an einem oder mehreren Empfangsorten (EO1, EO2, EO3) ein von der Entladung (EE) verursachter Schallimpuls (SI) erfasst, woraus eine jeweilige Impulslaufzeit (IT(EO)) des Schallimpulses (SI) zum jeweiligen Empfangsort (EO1, EO2, EO3) ermittelt wird. Darüber hinaus wird ein eine Vielzahl von Volumenelementen (VE) umfassendes volumetrisches Modell (VM) der elektrischen Anlage (TR) bereitgestellt, wobei einem jeweiligen Volumenelement (VE) eine ortsaufgelöste Schallgeschwindigkeit (V(VE)) individuell zugeordnet ist. Für einen jeweiligen Empfangsort (EO1, EO2, EO3) wird einem jeweiligen Volumenelement (VE) abhängig von einer zugeordneten Schallgeschwindigkeit (V(VE)) eine volumenelementspezifische Schalllaufzeit (T(VE,EO)) zwischen dem jeweiligen Empfangsort und dem jeweiligen Volumenelement zugeordnet. Weiterhin wird für ein jeweiliges Volumenelement (VE) ein Abstand (D(VE)) der Impulslaufzeiten (IT(EO)) von den diesem Volumenelement (VE) zugeordneten Schalllaufzeiten (T(VE,EO)) ermittelt. Abhängig von den ermittelten Abständen (D(VE)) wird dann ein Volumenelement (SVE) als Position der Entladung (EE) selektiert.

## Beschreibung

In elektrischen Anlagen können insbesondere bei hohen Spannungen elektrische Entladungen auftreten, die häufig eine Beschädigung der Anlage herbeiführen. Eine Fehlersuche, Ursachensuche oder Reparatur kann in der Regel erheblich verkürzt werden, wenn ein Ort der Entladung möglichst schnell und genau lokalisiert werden kann. Dies gilt insbesondere bei Entladungen, die an schwer zugänglichen oder schlecht einsehbaren Stellen, wie beispielsweise im Inneren eines Transformators auftreten. Bei Transformatoren ist es zudem aus Gründen der elektrischen Isolation meist schwierig, Sensoren im Inneren des Transformators anzubringen.

Aus den Publikationen "Experiences with the acoustic localization of partial discharge in fluid-isolated power transformers with the help of UHF measurement technology" von S. Hoeck in OMICRON Energy Solutions, Berlin, 2014 und "New methods for multisource PD localization on power transformers by an acoustic sensor array" von M. Siegel et al. vom 18th International Symposium on High Voltage Engineering, South Korea, 2013 sind Verfahren zur akustischen Lokalisierung von Entladungen in Transformatoren bekannt. Die dort beschriebenen Verfahren weisen jedoch nur eine begrenzte Lokalisierungsgenauigkeit auf.

Es ist Aufgabe der vorliegenden Erfindung, ein Verfahren und eine Anordnung zum Lokalisieren einer elektrischen Entladung in einer elektrischen Anlage zu schaffen, die eine genauere Lokalisierung erlauben.

Gelöst wird diese Aufgabe durch ein Verfahren mit den Merkmalen des Patentanspruchs 1, durch eine Anordnung mit den Merkmalen des Patentanspruchs 9, durch ein Computerprogrammprodukt mit den Merkmalen des Patentanspruchs 10 und durch ein computerlesbares Speichermedium mit den Merkmalen des Patentanspruchs 11.

Zum Lokalisieren einer elektrischen Entladung in einer elektrischen Anlage wird ein Entladungszeitpunkt der Entladung erfasst. Weiterhin wird ein von der Entladung verursachter Schallimpuls an einem oder mehreren Empfangsorten erfasst, und es wird eine jeweilige Impulslaufzeit des Schallimpulses zum jeweiligen Empfangsort ermittelt. Erfindungsgemäß wird ein eine Vielzahl von Volumenelementen umfassendes volumetrisches Modell der elektrischen Anlage bereitgestellt, wobei einem jeweiligen Volumenelement eine ortsaufgelöste Schallgeschwindigkeit individuell zugeordnet ist. Für einen jeweiligen Empfangsort wird einem jeweiligen Volumenelement abhängig von einer zugeordneten Schallgeschwindigkeit eine volumenelementspezifische Schalllaufzeit zwischen dem jeweiligen Empfangsort und dem jeweiligen Volumenelement zugeordnet. Weiterhin wird für ein jeweiliges Volumenelement ein Abstand der Impulslaufzeiten von den diesem Volumenelement zugeordneten Schalllaufzeiten ermittelt. Abhängig von den ermittelten Abständen wird dann ein Volumenelement als Position der Entladung selektiert.

Zum Ausführen des erfindungsgemäßen Verfahrens sind eine Anordnung zum Lokalisieren einer elektrischen Entladung in einer elektrischen Anlage, ein Computerprogrammprodukt sowie ein computerlesbares Speichermedium vorgesehen.

Das erfindungsgemäße Verfahren und die erfindungsgemäße Anordnung können beispielsweise mittels einem oder mehrerer Prozessoren, anwendungsspezifischen integrierten Schaltungen (ASIC), digitalen Signalprozessoren (DSP) und/oder sogenannten "Field Programmable Gate Arrays" (FPGA) ausgeführt bzw. implementiert werden.

Ein wesentlicher Vorteil der Erfindung ist darin zu sehen, dass Entladungen auch in elektrischen Anlagen mit heterogener Innenstruktur mit hoher Genauigkeit lokalisiert werden können. Die Entladungen sind dabei insbesondere im laufenden Betrieb lokalisierbar.

Durch die verbesserte Lokalisierung von Entladungen kann die Erfindung vorteilhaft z.B. zum Überwachen, zum Testen, zur Wartung, zur Diagnose, zur Inspektion, zur Risikoabschätzung und/oder zur Schadensbegrenzung bei elektrischen Anlagen eingesetzt werden. Insbesondere kann während einer Entwicklungs- oder Testphase von elektrischen Anlagen deren Durchschlagfestigkeit ortsaufgelöst geprüft werden.

Vorteilhafte Ausführungsformen und Weiterbildungen der Erfindung sind in den abhängigen Ansprüchen angegeben.

Nach einer vorteilhaften Ausführungsform der Erfindung kann der Entladungszeitpunkt mittels eines elektrischen, magnetischen und/oder elektromagnetischen Sensors erfasst werden. Dies kann insbesondere anhand eines von der Entladung verursachten elektromagnetischen Impulses, z.B. mittels eines Funkempfängers als elektromagnetischem Sensor erfolgen. Alternativ oder zusätzlich kann der Entladungszeitpunkt anhand eines von der Entladung verursachten Spannungsabfalls, Kurzschlussstroms oder anderen Signals der elektrischen Anlage erfasst werden. Aufgrund der hohen Ausbreitungsgeschwindigkeit von elektrischen, magnetischen oder elektromagnetischen Signalen kann der Entladungszeitpunkt in der Regel quasi instantan erfasst und damit sehr genau ermittelt werden.

Vorzugsweise kann der Schallimpuls an einem oder mehreren Empfangsorten erfasst werden, die an einem Gehäuse der elektrischen Anlage angeordnet sind. Insbesondere können ein oder mehrere Empfangsorte relativ zu möglichen Entladungsorten im Inneren der elektrischen Anlage fixiert sein.

Weiterhin kann ein Volumenelement mit minimalem zugeordnetem Abstand als Position der elektrischen Entladung selektiert werden. Eine derart selektierte Position kann als wahrscheinlichster Ort der Entladung ausgegeben, dargestellt und/oder in besonderer Weise hervorgehoben werden.

Nach einer vorteilhaften Ausführungsform der Erfindung kann als Abstand eine Summe von empfangsortspezifischen Einzelabständen jeweils zwischen einer Impulslaufzeit und einer dem jeweiligen Volumenelement zugeordneten Schalllaufzeit ermittelt werden. Als Einzelabstand kann z.B. ein Betrag oder ein Quadrat einer Differenz zwischen der jeweiligen Impulslaufzeit und der jeweiligen Schalllaufzeit verwendet werden. Die Summe kann gegebenenfalls durch vorgegebene, empfangsortspezifische Gewichte gewichtet werden.

Vorteilhafterweise kann aus dem für ein selektiertes Volumenelement ermittelten Abstand ein Maß für eine Ortsunsicherheit der Position der elektrischen Entladung abgeleitet werden. Ein solches Maß kann als Fehlerangabe, Lokalisierungsfehler bzw. Lokalisierungsgenauigkeit ausgegeben und/oder dargestellt werden. Das Maß kann im Rahmen der Erfindung praktisch ohne nennenswerten Zusatzaufwand bestimmt werden und ist essentiell für eine Beurteilung der Genauigkeit oder Zuverlässigkeit einer Lokalisierung.

Gemäß einer vorteilhaften Ausführungsform der Erfindung können die volumenelementspezifischen Schalllaufzeiten durch numerisches Lösen einer Eikonal-Gleichung anhand des volumetrischen Modells ermittelt werden. Vorzugsweise wird die Eikonal-Gleichung in umgekehrter Zeitrichtung gelöst.

Zum Lösen der Eikonal-Gleichung kann insbesondere ein fast-marching-Verfahren, Bellman-Ford-Verfahren und/oder ein fast-sweeping-Verfahren eingesetzt werden. Die genannten Verfahren erlauben eine besonders effiziente numerische Lösung der Eikonal-Gleichung.

Ein Ausführungsbeispiel der Erfindung wird nachfolgend anhand der Zeichnung näher erläutert. Dabei zeigen jeweils in schematischer Darstellung:
- Figur 1: einen Transformator zusammen mit einer erfindungsgemäßen Anordnung zum Lokalisieren einer elektrischen Entladung im Transformator und
- Figur 2: eine simulierte Schallausbreitung im Transformator anhand eines volumetrischen Modells des Transformators.

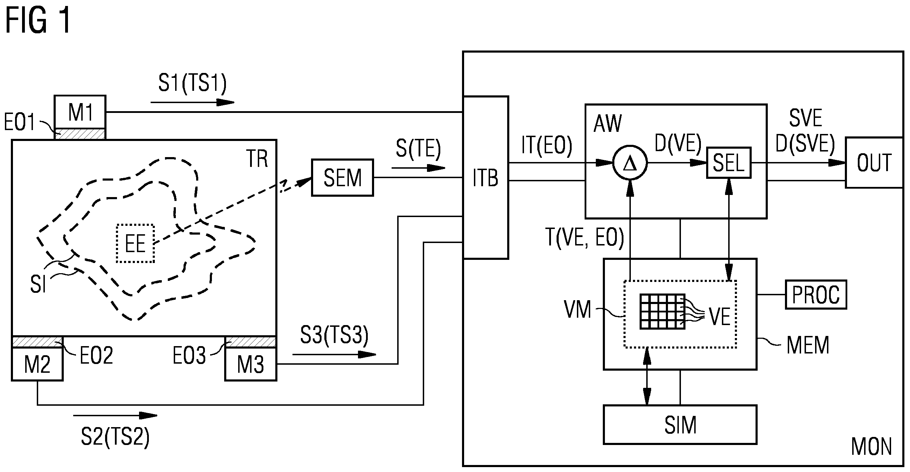

In Figur 1 ist ein Transformator TR als elektrische Anlage zusammen mit einer erfindungsgemäßen Anordnung zum Lokalisieren einer elektrischen Entladung EE im Transformator TR schematisch dargestellt. Anstelle des Transformators TR oder zusätzlich zum Transformator TR kann ein Gleichrichter, ein Wechselrichter, ein Stromnetz, ein Generator oder eine andere elektrische Anlage vorgesehen sein.

Der Transformator TR verfügt über eine komplexe Innenstruktur mit einer Vielzahl unterschiedlicher Materialien, wie zum Beispiel verschiedenen Metallen, Transformatorenöl, Holz und Papier. Insbesondere beinhaltet der Transformator TR Materialen, die sehr unterschiedliche, materialspezifische Schallgeschwindigkeiten aufweisen. Dies bedeutet, dass sich eine Schallwelle im Inneren des Transformators TR mit lokal sehr unterschiedlicher Geschwindigkeit fortpflanzt. Somit führt die hinsichtlich der Schallgeschwindigkeit heterogene Innenstruktur des Transformators TR in der Regel zu einer komplexen Schallausbreitung in dessen Innerem.

Die Entladung EE im Inneren des Transformators TR kann zum Beispiel ein Funken, ein Lichtbogen oder ein anderes elektroakustisches Ereignis sein. Insofern derartige Entladungen eine Funktionsfähigkeit des Transformators TR bis hin zu dessen Zerstörung beeinträchtigen kann, ist es häufig sehr wichtig, die Entladung zu lokalisieren.

Die Entladung EE löst sowohl einen elektromagnetischen Impuls als auch einen Schallimpuls SI aus. Der elektromagnetische Impuls ist in Figur 1 durch einen strichlierten Blitz und der Schallimpuls SI durch strichlierte Wellenfronten veranschaulicht. Aufgrund der heterogenen Innenstruktur des Transformators TR und den damit einhergehenden lokal stark variierenden Schallgeschwindigkeiten weichen die Wellenfronten des Schallimpulses in der Regel stark von einer Kugelform ab.

Die erfindungsgemäße Anordnung verfügt über einen elektromagnetischen Sensor SEM, der den von der Entladung EE verursachten elektromagnetischen Impuls erfasst. Der elektromagnetische Sensor SEM, zum Beispiel ein Funkempfänger, übermittelt infolge des Empfangs des elektromagnetischen Impulses ein Sensorsignal S an eine ebenfalls zur erfindungsgemäßen Anordnung gehörige Überwachungseinrichtung MON. Die Überwachungseinrichtung MON erfasst anhand des Sensorsignals S einen Entladungszeitpunkt TE der Entladung EE. Alternativ oder zusätzlich kann der Entladungszeitpunkt TE anhand eines von der Entladung EE verursachten Spannungsabfalls, Kurzschlussstroms oder anderen Signals des Transformators TR, zum Beispiel mittels eines elektrischen oder magnetischen Sensors bestimmt werden. Aufgrund der hohen Ausbreitungsgeschwindigkeit des elektromagnetischen Impulses ist die Entladung EE quasi instantan detektierbar und der Entladungszeitpunkt TE sehr genau ermittelbar.

Die erfindungsgemäße Anordnung verfügt weiterhin über mehrere Mikrofone M1, M2 und M3 oder andere akustische Sensoren, die vorzugsweise am Gehäuse des Transformators TR angeordnet sind. Die Mikrofone M1, M2 und M3 erfassen den Schallimpuls SI jeweils unabhängig voneinander an einem jeweiligen Empfangsort EO1, EO2 bzw. EO3. Infolge der jeweiligen Erfassung des Schallimpulses SI übermittelt ein jeweiliges Mikrofon M1, M2 bzw. M3 ein Sensorsignal S1, S2 bzw. S3 an die Überwachungseinrichtung MON, die anhand dieser Sensorsignale einen jeweiligen Empfangszeitpunkt TS1, TS2 bzw. TS3 des Schallimpulses SI am jeweiligen Empfangsort EO1, EO2 bzw. EO3 empfangsortspezifisch erfasst.

Die Überwachungseinrichtung MON dient zum Lokalisieren der Entladung EE im Inneren des Transformators TR anhand des Entladungszeitpunktes TE und der Empfangszeitpunkte TS1, TS2 und TS3. Die Überwachungseinrichtung MON ist an den elektromagnetischen Sensor SEM sowie an die Mikrofone M1, M2 und M3 gekoppelt.

Die Überwachungseinrichtung MON verfügt über einen oder mehrere Prozessoren PROC zum Ausführen von Verfahrensschritten der Erfindung sowie über eine oder mehrere mit dem Prozessor PROC gekoppelte Speicher MEM zum Speichern der von der Überwachungseinrichtung MON zu verarbeiteten Daten. Insbesondere dient der Speicher MEM zum Speichern eines eine Vielzahl von Volumenelementen VE umfassenden volumetrischen Modells VM des Transformators TR.

Die Überwachungseinrichtung MON verfügt weiterhin über ein Impulslaufzeitbestimmungsmodul ITB, das die Sensorsignale S, S1, S2 sowie S3 empfängt und den Entladungszeitpunkt TE sowie die Empfangszeitpunkte TS1, TS2 und TS3 erfasst. Durch das Impulslaufzeitbestimmungsmodul ITB wird aus dem Entladungszeitpunkt TE und den Empfangszeitpunkten TS1, TS2 und TS3 eine jeweilige empfangsortspezifische Impulslaufzeit IT1, IT2 bzw. IT3 des Schallimpulses SI vom Ort der Entladung EE bis zum jeweiligen Empfangsort EO1, EO2 bzw. EO3 ermittelt. Die Ermittlung erfolgt vorzugsweise durch Differenzbildung gemäß IT1 = TS1-TE, IT2 = TS2-TE und IT3 = TS3-TE.

Die Impulslaufzeiten IT1, IT2 und IT3 werden im Folgenden auch als IT(EO) bezeichnet, wobei EO als über die Empfangsorte EO1, EO2 und EO3 laufender Index aufgefasst wird.

Die ermittelten Impulslaufzeiten IT(EO) des Schallimpulses SI werden vom Impulslaufzeitbestimmungsmodul ITB zu einem damit gekoppelten Auswertemodul AW der Überwachungseinrichtung MON übermittelt.

Das Überwachungsmodul MON weist weiterhin ein Simulationsmodul SIM auf, das mit dem Speicher MEM gekoppelt ist und Zugriff auf das darin gespeicherte volumetrische Modell VM hat. Das Simulationsmodul SIM dient zum Simulieren einer Schallausbreitung im Inneren des Transformators TR anhand des volumetrischen Modells VM und insbesondere zum Bestimmen einer jeweiligen Schalllaufzeit zwischen einem jeweiligen Empfangsort, hier EO1, EO2 bzw. EO3, und einem jeweiligen Volumenelement VE des volumetrischen Modells VM. Diese Schalllaufzeiten sind in Figur 1 als T(VE, EO) bezeichnet, wobei VE als über die Volumenelemente VE laufender Index und EO als über die Empfangsorte EO1, EO2 und EO3 laufender Index aufgefasst wird. Offensichtlich sind die Schalllaufzeiten T(VE, EO) sowohl volumenelementspezifisch, als auch empfangsortspezifisch.

Durch das Simulationsmodul SIM werden für ein jeweiliges Volumenelement VE die Schalllaufzeiten T(VE, EO) zwischen diesem Volumenelement VE und den verschiedenen Empfangsorten, hier EO1, EO2 und EO3, separat ermittelt und diesem Volumenelement VE zugeordnet. Die Schalllaufzeiten T(VE, EO) können vorzugsweise für alle Empfangsorte und alle Volumenelemente vorab berechnet und im volumetrischen Modell VM, das heißt in einer das volumetrische Modell VM implementierenden Datenstruktur gespeichert werden. Zum Ermitteln der Schalllaufzeiten T(VE, EO) wird durch das Simulationsmodul SIM eine Schallausbreitung im Transformator TR anhand des volumetrischen Modells VM simuliert.

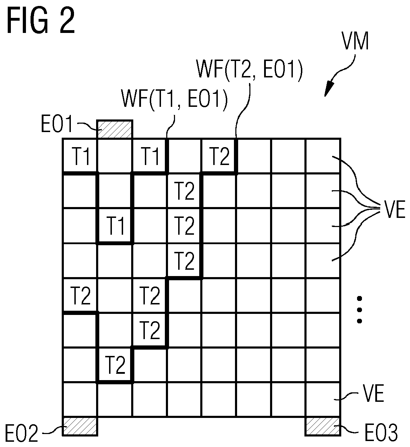

Figur 2 veranschaulicht eine solche simulierte Schallausbreitung im Transformator TR anhand des volumetrischen Modells VM. Erfindungsgemäß ist jedem der Volumenelemente VE des volumetrischen Modells VM eine für dieses Volumenelement VE spezifische, ortsaufgelöste Schallgeschwindigkeit V(VE) individuell zugeordnet.

Das volumetrische Modell VM ist im vorliegenden Ausführungsbeispiel ein dreidimensionales Modell des Transformators TR mit einer Vielzahl von zum Beispiel in einem dreidimensionalen Gitter oder in einer dreidimensionalen Triangulierung angeordneten Volumenelementen VE. Das volumetrische Modell VM wird vorzugsweise durch einen räumlich aufgelösten Datensatz dargestellt, in dem für jedes Volumenelement VE des dreidimensionalen Gitters oder der dreidimensionalen Triangulierung ein lokaler, räumlich aufgelöster Wert für die in diesem Volumenelement VE vorliegende Schallgeschwindigkeit V(VE) gespeichert ist. Derartige Volumenelemente auf einem dreidimensionalen Gitter oder einer dreidimensionalen Triangulierung werden häufig auch als Voxel bezeichnet.

Im volumetrischen Modell VM sind die im Zusammenhang mit Figur 1 beschriebenen Empfangsorte EO1, EO2 und EO3 den ihrer räumlichen Position entsprechenden Volumenelementen zugeordnetet.

Das Simulationsmodul SIM ermittelt - wie oben bereits erwähnt - für ein jeweiliges Volumenelement VE und einen jeweiligen Empfangsort EO die simulierte Schalllaufzeit T(VE, EO) zwischen dem jeweiligen Empfangsort EO und dem jeweiligen Volumenelement VE. Zu diesem Zweck wird ein Fortschreiten einer Wellenfront WF eines von einem jeweiligen Empfangsort, in Figur 2 beispielhaft EO1, ausgehenden Schallimpulses durch das inhomogene Innere des Transformators TR anhand des volumetrischen Models VM simuliert. Das Fortschreiten der Wellenfront WF erfolgt hierbei lokal individuell gemäß der volumenelementspezifischen Schallgeschwindigkeit V(VE).

In Figur 2 ist ein Verlauf der von EO1 ausgehenden Wellenfront zu verschiedenen Zeiten durch verdickte Linien angedeutet; und zwar ein Wellenfrontverlauf WF(T1, EO1) nach einer Schalllaufzeit T1 sowie ein Wellenfrontverlauf WF(T2, EO1) nach einer Schalllaufzeit T2. Im Rahmen der Simulation wird den vom Wellenfrontverlauf WF(T1, EO1) neu erreichten Volumenelementen die für den Empfangsort EO1 spezifische Schalllaufzeit T1 zugeordnet und den vom Wellenfrontverlauf WF(T2, EO1) neu erreichten Volumenelementen die für den Empfangsort EO1 spezifische Schalllaufzeit T2.

Die für die anderen Empfangsorte EO2 und EO3 spezifischen Schalllaufzeiten beziehungsweise Wellenfronten werden durch das Simulationsmodul SIM in analoger Weise ermittelt und im volumetrischen Modell VM gespeichert.

Im vorliegenden Ausführungsbeispiel werden die Schalllaufzeiten T(VE, EO) anhand des volumetrischen Modells VM durch numerisches Lösen einer Eikonal-Gleichung durch das Simulationsmodul SIM berechnet. Vorzugsweise wird für jeden Empfangsort EO die Gleichung |gradₓ T(x,EO) | = 1/V(x) mit x als räumlicher Ortsvariable, die hier die Volumenelemente VE durchläuft, mit der Randbedingung T(EO,EO)=0 numerisch gelöst. Zur Lösung wird vorzugsweise ein fast-marching-Verfahren verwendet. Alternativ oder ergänzend kann ein Bellman-Ford-Verfahren und/oder ein fast-sweeping-Verfahren zur Lösung eingesetzt werden.

Wie in Figur 1 veranschaulicht, greift das Auswertemodul AW auf die vom Simulationsmodul SIM ermittelten und im volumetrischen Modell VM gespeicherten Schalllaufzeiten T(VE, EO) zu, um für jedes Volumenelement VE einen Abstand D(VE) der Impulslaufzeiten IT(EO) von den diesem Volumenelement VE zugeordneten Schalllaufzeiten T(VE, EO) zu ermitteln.

Als volumenelementspezifischer Abstand D(VE) kann ein mehrdimensionaler, zum Beispiel euklidischer Abstand berechnet werden. Im vorliegenden Ausführungsbeispiel wird der Abstand D(VE) für ein jeweiliges Volumenelement VE als Summe von empfangsortspezifischen Einzelabständen DS(VE, EO) jeweils zwischen einer empfangsortspezifischen Impulslaufzeit IT(EO) und einer dem jeweiligen Volumenelement VE zugeordneten, empfangsortspezifischen Schalllaufzeit T(VE, EO) ermittelt.

Ein volumenelementspezifischer und empfangsortspezifischer Einzelabstand DS(VE, EO) kann beispielsweise berechnet werden gemäß DS(VE, EO) = |IT(EO)-T(VE, EO)| oder als quadratischer Einzelabstand gemäß DS(VE, EO)=(IT(EO)-T(VE, EO))².
Daraus kann der volumenelementspezifische Abstand D(VE) ermittelt werden gemäß D(VE) = ∑_{EO} DS(VE, EO), wobei im vorliegenden Ausführungsbeispiel der Summenindex EO über die Empfangsorte EO1, EO2 und EO3 läuft. Gegebenenfalls können die Summanden mit einem empfangsortspezifischen Gewichtungsfaktor gewichtet werden.

Der Abstand D(VE) kann als Maß dafür aufgefasst werden, wie unsicher es ist, dass die Entladung EE im betreffenden Volumenelement VE erfolgt ist. Je größer der Abstand D(VE) ist, das heißt je geringer die Übereinstimmung der tatsächlichen Impulslaufzeiten IT(EO) mit den für dieses Volumenelement VE per Simulation bestimmten Schalllaufzeiten T(VE, EO) ist, desto geringer ist die Wahrscheinlichkeit, dass die Entladung EE im betreffenden Volumenelement VE erfolgt ist.

Die Abstände D(VE) werden zu einem Selektionsmodul SEL des Auswertemoduls AW übermittelt. Das Selektionsmodul SEL dient zum Selektieren eines oder mehrerer Volumenelemente SVE als mögliche Postionen der Entladung EE abhängig von den Abständen D(VE). Zu diesem Zweck vergleicht das Selektionsmodul SEL die Abstände D(VE) für verschiedene Volumenelemente untereinander und/oder mit einem oder mehreren Schwellwerten. Abhängig davon werden dann ein oder mehrere Volumenelente SVE selektiert, die einen minimalen oder besonders geringen Abstand und/oder einen Abstand unterhalb eines Schwellwerts aufweisen. Vorzugsweise wird dabei ein Volumenelement mit minimalem zugeordnetem Abstand als wahrscheinlichste Position der Entladung EE spezifisch selektiert.

Die selektierten Volumenelemente SVE und/oder deren räumliche Positionen werden vom Selektionsmodul SEL jeweils zusammen mit einem zugeordneten Abstand D(SVE) zu einer mit dem Auswertemodul AW gekoppelten Ausgabeeinrichtung OUT der Überwachungseinrichtung MON übermittelt.

Die Ausgabeeinrichtung OUT, zum Beispiel ein Terminal, dient zur Ausgabe des oder der selektierten Volumenelemente SVE bzw. deren Positionen als wahrscheinliche Positionen der Entladung EE. Die selektierten Volumenelemente SVE bzw. deren Positionen werden vorzugsweise zusammen mit den zugeordneten Abständen D(SVE) als jeweilige Ortsunsicherheit ausgegeben. Insbesondere können die wahrscheinlichen Positionen der Entladung EE durch die Ausgabeeinrichtung OUT anhand der selektierten Volumenelemente SVE und den zugeordneten Abständen D(SVE) visualisiert werden. Beispielsweise indem die selektierten Volumenelemente SVE in einem visualisierten Strukturmodell des Transformators TR abhängig vom jeweils zugeordneten Abstand D(SVE) zum Beispiel durch Helligkeit, Farbe, Transparenz und/oder Sättigung hervorgehoben werden. Dabei wird ein jeweiliges selektiertes Volumenelement SVE umso stärker hervorgehoben, je kleiner der zugeordnete Abstand D(SVE) ist. Auf diese Weise wird die wahrscheinlichste Position der Entladung EE am stärksten hervorgehoben und weniger wahrscheinliche Positionen werden geringer hervorgehoben. Auf diese Weise sind eine mögliche Position der Entladung EE sowie ein möglicher Lokalisierungsfehler für einen Benutzer schnell und intuitiv erkennbar.

Mittels der Erfindung können elektrische Entladungen mit hoher Genauigkeit auch in Anlagen mit heterogener und schwer zugänglicher Innenstruktur lokalisiert werden. Darüber hinaus steht mit den parallel ermittelten Abständen D(VE) ein ortsaufgelöstes Maß für eine Ortsunsicherheit oder Präzision der Lokalisierung zur Verfügung.

## Patentansprüche

1. Verfahren zum Lokalisieren einer elektrischen Entladung (EE) in einer elektrischen Anlage (TR), wobei
a) ein Entladungszeitpunkt (TE) der Entladung (EE) erfasst wird,
b) ein von der Entladung (EE) verursachter Schallimpuls (SI) an einem oder mehreren Empfangsorten (EO1, EO2, EO3) erfasst wird und eine jeweilige Impulslaufzeit (IT(EO)) des Schallimpulses (SI) zum jeweiligen Empfangsort (EO1, EO2, EO3) ermittelt wird,
c) ein eine Vielzahl von Volumenelementen (VE) umfassendes volumetrisches Modell (VM) der elektrischen Anlage (TR) bereitgestellt wird, wobei einem jeweiligen Volumenelement (VE) eine ortsaufgelöste Schallgeschwindigkeit (V(VE)) individuell zugeordnet ist,
d) für einen jeweiligen Empfangsort (EO1, EO2, EO3) einem jeweiligen Volumenelement (VE) abhängig von einer zugeordneten Schallgeschwindigkeit (V(VE)) eine volumenelementspezifische Schalllaufzeit (T(VE,EO)) zwischen dem jeweiligen Empfangsort und dem jeweiligen Volumenelement zugeordnet wird,
e) für ein jeweiliges Volumenelement (VE) ein Abstand (D(VE)) der Impulslaufzeiten (IT(EO)) von den diesem Volumenelement (VE) zugeordneten Schalllaufzeiten (T(VE,EO)) ermittelt wird, und
f) abhängig von den ermittelten Abständen (D(VE)) ein Volumenelement (SVE) als Position der Entladung (EE) selektiert wird.

2. Verfahren nach Anspruch 1, **dadurch gekennzeichnet, dass** der Entladungszeitpunkt (TE) mittels eines elektrischen, magnetischen und/oder elektromagnetischen Sensors (SEM) erfasst wird.

3. Verfahren nach einem der vorhergehenden Ansprüche, **dadurch gekennzeichnet, dass**
der Schallimpuls (SI) an einem oder mehreren Empfangsorten (EO1, EO2, EO3) erfasst wird, die an einem Gehäuse der elektrischen Anlage (TR) angeordnet sind.

4. Verfahren nach einem der vorhergehenden Ansprüche, **dadurch gekennzeichnet, dass**
ein Volumenelement mit minimalem zugeordnetem Abstand als Position der Entladung (EE) selektiert wird.

5. Verfahren nach einem der vorhergehenden Ansprüche, **dadurch gekennzeichnet, dass**
als Abstand (D(VE)) eine Summe von empfangsortspezifischen Einzelabständen jeweils zwischen einer Impulslaufzeit und einer dem jeweiligen Volumenelement zugeordneten Schalllaufzeit ermittelt wird.

6. Verfahren nach einem der vorhergehenden Ansprüche, **dadurch gekennzeichnet, dass**
aus dem für ein selektiertes Volumenelement (SVE) ermittelten Abstand (D(SVE)) ein Maß für eine Ortsunsicherheit der Position der Entladung (EE) abgeleitet wird.

7. Verfahren nach einem der vorhergehenden Ansprüche, **dadurch gekennzeichnet, dass**
die volumenelementspezifischen Schalllaufzeiten (T(VE, EO)) durch numerisches Lösen einer Eikonal-Gleichung anhand des volumetrischen Modells (VM) ermittelt werden.

8. Verfahren nach Anspruch 7, **dadurch gekennzeichnet, dass** die Lösung der Eikonal-Gleichung mittels eines fast-marching-Verfahrens, Bellman-Ford-Verfahrens und/oder fast-sweeping-Verfahrens erfolgt.

9. Anordnung zum Lokalisieren einer elektrischen Entladung (EE) in einer elektrischen Anlage (TR), eingerichtet zum Ausführen eines Verfahrens nach einem der vorhergehenden Ansprüche.

10. Computerprogrammprodukt eingerichtet zum Ausführen eines Verfahrens nach einem der Ansprüche 1 bis 8.

11. Computerlesbares Speichermedium mit einem Computerprogrammprodukt nach Anspruch 10.
